(19) Europäisches Patentamt
European Patent Office
Office européen des brevets

(11) Publication number: **0 135 900**
**A2**

(12) # EUROPEAN PATENT APPLICATION

(21) Application number: **84110995.2**

(51) Int. Cl.⁴: **G 03 F 7/10**

(22) Date of filing: **14.09.84**

(30) Priority: **16.09.83 US 533139**

(43) Date of publication of application: **03.04.85**
**Bulletin 85/14**

(84) Designated Contracting States: **BE DE FR GB IT**

(71) Applicant: **PHILIP A. HUNT CHEMICAL CORP., Palisades Park New Jersey 07650 (US)**

(72) Inventor: **Toukhy, Medhat A., 7 Congress Road, Barrington Rhode Island 02806 (US)**

(74) Representative: **Vossius Vossius Tauchner Heunemann Rauh, Siebertstrasse 4 P.O. Box 86 07 67, D-8000 München 86 (DE)**

(54) **Aqueous developable negative resist compositions.**

(57) Aqueous developable negative resist compositions are provided which are useful in ultra violet lithography and in electron beam lithography and which contain a polymer system comprising a phenolic resin and a novolak-type resin compatible with the phenolic resin, a sensitizer, and a solvent in which all three components are readily soluble. The negative resist composition of the present invention produces a resist which exhibits higher resolution than conventional cyclized rubber negative resists, does not swell during development as do such conventional negative resists, and which can be developed with aqueous alkaline developers.

EP 0 135 900 A2

VOSSIUS · VOSSIUS · TAUCHNER
HEUNEMANN · RAUH
PATENTANWÄLTE
SIEBERTSTR. 4, 8000 MÜNCHEN 80
TEL. (089) 47 4075

0135900
7. Sep. 1984

Our Ref.: T 253 EP
Case: 150 EPO

Philip A. Hunt Chemical Corporation
Palisades Park, New Jersey 07650, U.S.A.

# AQUEOUS DEVELOPABLE NEGATIVE RESIST COMPOSITIONS

## Field Of The Invention

The present invention relates to negative resist compositions useful in ultra violet lithography and in electron beam lithography. More particularly, the present invention relates to aqueous developable negative resist compositions sensitive to radiation in at least one of the near, middle and deep ultra violet regions of the spectrum, which are developable with aqueous alkaline developers and which have the ability to resolve micron size geometries in the fabrication of semiconductor devices.

## Background Of The Invention

Resists are materials which, when exposed to high energy, such as an electron beam, or radiation of the proper wavelength, such as ultra violet radiation, are chemically changed in their solubility or removability characteristics in certain solvents or developers. To develop a resist generally means to remove, by whatever means, those areas of the resist which are more easily removable after the resist is exposed. A common and convenient means of development is through solvents which dissolve the more easily removed portion of the selectively exposed

resist layer, but leave the remaining portions substantially intact. A material is "developable" if it is removable by any of the standard methods of development known to those skilled in the art.

Two types of resists are available, negative-acting and positive-acting resists. Prior to exposure, negative-acting resists are soluble in developer, but with exposure they undergo chemical change and become insoluble in such developers. After selective exposure, the unexposed areas of the resist are selectively dissolved, softened, or washed away, leaving the desired resist pattern on a substrate. The remaining resist pattern is used to protect the substrate in, for example, etching processes, where surface etching of the substrate is desired only in the areas which underlie the unexposed resist.

Positive-acting resists work in the opposite manner, with exposure making the resists soluble in the developer. In either case, the resist pattern that remains after development and, in some cases, post baking, is insoluble and chemically resistent to the cleaning, plating, etching or other solutions used in treating the substrate.

Resists are used in the formation of integrated circuits, printed circuit boards, photolithographs, name plates and the like. Resists are particularly useful in the electronics industry where a typical operation might be the coating of a substrate, such as a silicon wafer with a thin film of a resist which is then exposed through either a positive or a negative of the desired image. If the resist used is a positive-acting material, the exposed areas of the resist layer are rendered soluble by the exposure, and are removed by washing with a developer to uncover the underlying metal layer. The areas surrounding the uncovered metal,

which were not exposed remain and protect the portions of the metal layer which they overlie. An etchant to which the resist is impervious may then be used to etch away the uncovered metal areas, or selective plating or other processes may be accomplished, and there remains a layer of resist in the desired image pattern. Later in the manufacturing process, the remaining resist pattern may or may not be removed, as desired.

It is well established in the resist art that utilizing radiation in the deep ultra violet region of the spectrum for exposure of resist-coated substrates results in a great increase in resolution in the developed resist and enables the reproduction of lines and spaces of very small dimensions with high image-edge acuity. The ability of a resist to reproduce very small dimensions, on the order of a micron or less is extremely important in the production of large scale integrated circuits on silicon chips and similar components. Circuit density on such a chip can be increased, assuming photolithography techniques are utilized, by increasing the resolution capabilities of the resist. Deep ultra violet lithography is a rapidly maturing technology. Both 1:1 scanning projection aligners and contact/proximity aligners are commercially available in deep ultra violet configurations, and feasibility of deep ultra violet step and repeat aligners is currently being investigated. However, conventional resists do not have adequate resolution and sensitivity in the deep ultra violet range of the spectrum.

Methacrylate resins, based on polymethyl methacrylate and sensitized polymethyl isopropenyl ketone have been used as high resolution positive deep ultra violet resists. However, their sensitivity to deep ultra violet radiation and resistance

to dry etching are not sufficient for use in practical deep ultra violet lithography processes. Positive resist systems based on a novolak resin and an ortho-naphthoquinone sensitizer have been tried as deep ultra violet resists but produce images having poor profiles. The lack of high power light sources for deep ultra violet lithography requires that the deep ultra violet resists be highly sensitive. Resists for fine line lithography also need to be capable of high resolution and compatible with the dry etching environments. The deep ultra violet positive resists do not meet these requirements.

Negative deep ultra violet resists employing chloromethylated polystyrene and an aromatic azide-cyclized polyisoprene system have also been tried. However, they exhibit low resolution when compared with the positive deep ultra violet resists and the resolution for these negative resists is limited by the swelling-induced deformation of the exposed resist patterns during development.

Thus, there currently exists a need for a deep ultra violet resist system with good sensitivity, high resolution, good processing latitude and thermostability.

## Summary Of The Invention

Aqueous developable negative resist compositions are provided which are useful in electron beam and in ultra violet lithography and which contain a polymer system comprising a phenolic resin having a weight average molecular weight of at least about 7,000 and a novolak-type resin compatible with the phenolic resin, a sensitizer, and a solvent in which all three components are readily soluble. The negative resist composition of the present invention produces a resist which exhibits higher resolution than conventional cyclized rubber negative

resists, does not swell during development as do such conventional negative resists, and which can be developed with aqueous alkaline developers. The negative resists of the present invention also exhibit high sensitivity to electron beams.

Description Of The Preferred Embodiments

The negative resist compositions of the present invention comprise a solution of a sensitizer and a polymer system comprising a phenolic resin and a novolak-type resin compatible with the phenolic resin, in a compatible solvent such that the solids content of the composition is at least about 15%. It is essential that the polymer system comprise a phenolic resin and a novolak-type resin since the use of either polymer alone in conjunction with the sensitizers of the present invention, does not result in a resist composition having properties comparable to those of the composition of the present invention.

The phenolic resin has a weight average molecular weight of at least about 7,000, more preferably within the range of from about 10,000 to about 40,000, and even more preferably within the range of from about 15,000 to about 30,000, and is present in the composition in an amount of from about 10% to about 95%, preferably from about 50% to about 95%, by weight of the polymer system in the composition. Phenolic resins useful in the present invention are represented by the following structural formula:

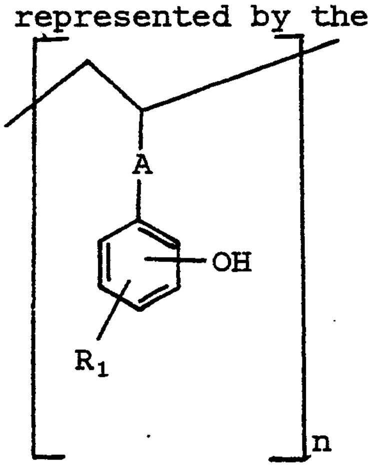

,

wherein A is a covalent bond, -O-, $-CH_2-$, -OC(O)-, -C(O)O-, or $-C(O)OCH_2-$, preferably a covalent bond or -OC(O)-, more preferably a covalent bond, and $R_1$ is -H, -F, -Cl, -Br, or -I, preferably -H or -F. Particularly preferred as the phenolic resin are those resins represented by the following structural formula:

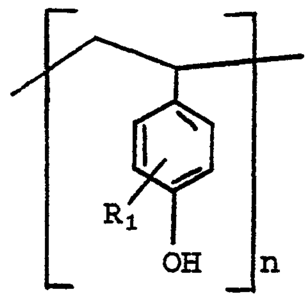

wherein $R_1$ has its previously assigned meaning.

The novolak-type resin useful in the present invention can be any such resin which is compatible with the phenolic resin both in coating characteristics, that is, which produces in combination with the pheolic resin a homogenous and uniform resist coating, and in rate of solubility in the aqueous alkaline developer. Preferred as the novolak-type resin is a cresol-formaldehyde novolak resin or a phenol-formaldehyde novolak resin. The cresol-formaldehyde novolak resins are particularly preferred and are preferably prepared as described in commonly assigned U.S. Patent 4,377,631. The novolak-type resin is present in an amount of from about 5% to about 90%, preferably from about 5% to about 50%, by weight of the polymer system in the composition. Suitable novolak-type resins are represented by the following structural formula:

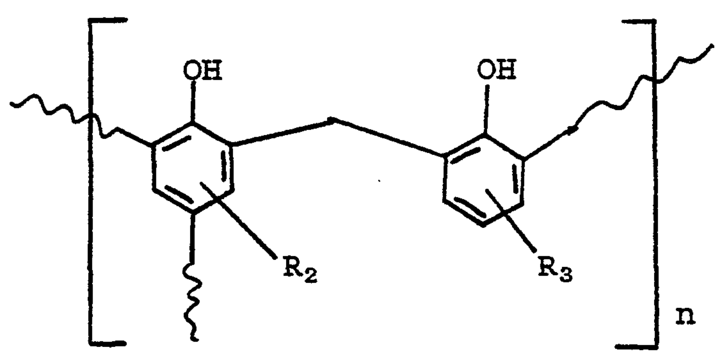

wherein $R_2$ and $R_3$ are independently -H or monovalent $C_1$ to $C_4$ alkyl.

The sensitizer is selected from the group consisting of bisarylazides, monoarylazides, and mixtures thereof provided that it is soluble in the composition in an amount sufficient to insolubilize the exposed photoresist. The concentration required will depend on the specific sensitivity of the sensitizer employed. Preferably, the sensitizer is selected from the group consisting of

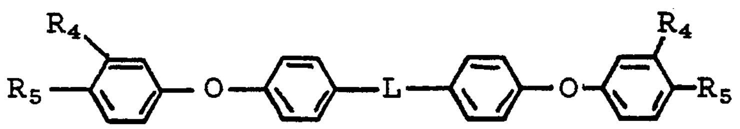
,

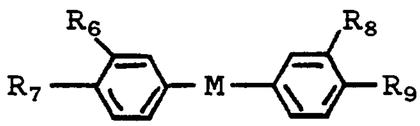
,
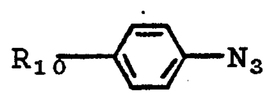

and mixtures thereof, wherein:

L is a covalent bond, $-CH_2-$, -CH=CH-, $-C(CH_3)_2-$, -CO-, $-SO_2-$, -O-, or -S-,

M is a covalent bond, $-CH_2$, -CH=CH-,

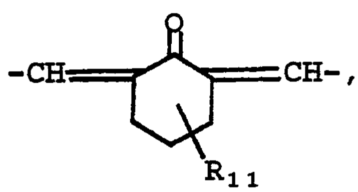
, -CH=CH-CO-, $-C(CH_3)_2-$,

-CO-, -S-, -O-, or $-SO_2-$,

$R_4$, $R_5$, $R_6$, $R_7$, $R_8$, $R_9$ and $R_{10}$ are selected independently from -H and $-N_3$, provided that $R_4 \neq R_5$, and provided that $R_6$ and $R_7$ cannot be $-N_3$ at the same time, $R_8$ and $R_9$ cannot be $-N_3$ at the same time and at least one of $R_6$, $R_7$, $R_8$ and $R_9$ is $-N_3$, and

$R_{11}$ is -H or monovalent $C_1$ to $C_9$ alkyl, preferably monovalent $C_1$ to $C_4$ alkyl, and more preferably $-CH(CH_3)_2$.

The sensitizer is present in an amount of from about 4% by weight based on total solids in the composition up to its saturation point, preferably from about 4% to about 35% by weight based on total solids in the composition. Preferred are those compounds in which $R_4$=-H and $R_5$=$-N_3$; those in which $R_6$=$R_8$ and $R_7$=$R_9$; and those in which $R_6$=$R_7$=-H.

When deep ultra violet sensitization is desired, the sensitizer is preferably selected from the group consisting of

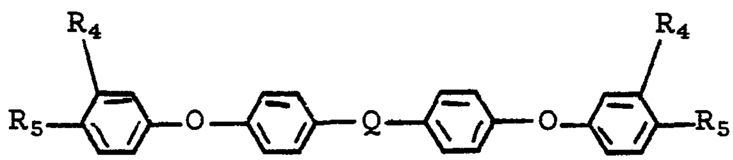
,
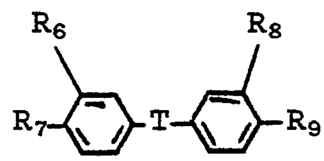

and mixtures thereof, wherein:

Q and T are selected independently from $-CH_2-$, $-C(CH_3)_2-$, -CO-, $-SO_2-$, -O-, and -S-, and

$R_4$, $R_5$, $R_6$, $R_7$, $R_8$ and $R_9$ have their previously assigned meanings.

A particularly preferred deep ultra violet sensitizer is

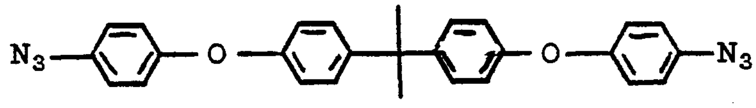
.

When near ultra violet sensitization is desired, the sensitizer is preferably selected from the group consisting of

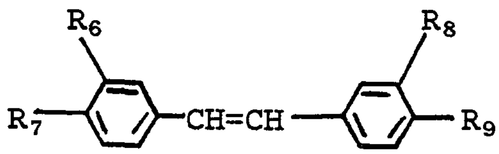 , 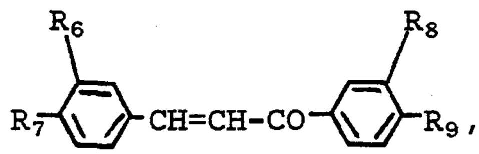 ,

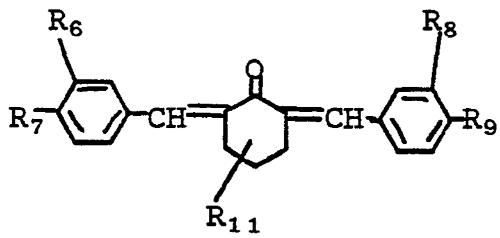 , 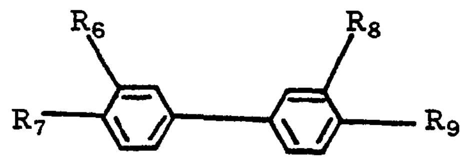 ,

and mixtures thereof, wherein:

$R_6$, $R_7$, $R_8$, $R_9$ and $R_{11}$ have their previously assigned meanings.

When extended near-deep ultra violet sensitization is desired, blends of the near and deep ultra violet sensitizers are employed.

The negative resist compositions contain the sensitizer, novolak-type resin and the phenolic resin in amounts such that the composition contains at least about 15% solids, preferably from about 15% to about 40% solids, and more preferably from about 20% to about 30% solids.

A particularly preferred deep ultra violet sensitive negative resist composition comprises a solution of a deep ultra violet sensitizer and a polymer system comprising a polyvinyl phenol compound and a novolak-type resin compatible with the phenolic resin, in which the deep ultra violet sensitizer is a compound selected from the group consisting of

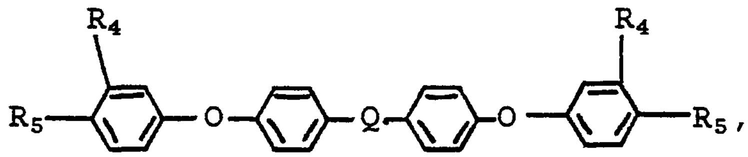

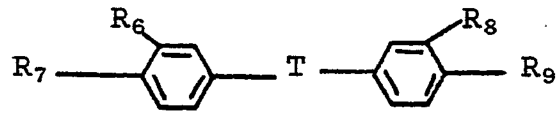

and mixtures thereof, wherein Q, T, $R_4$, $R_5$, $R_6$, $R_7$, $R_8$ and $R_9$ have their previously assigned meanings, and is present in an amount of about 4% by weight of the total solids in the composition up to the saturation point of the sensitizer, preferably from about 4% to about 35%, the phenolic resin has a weight average molecular weight of at least about 7,000, preferably from about 10,000 to about 40,000, and is represented by the following structure

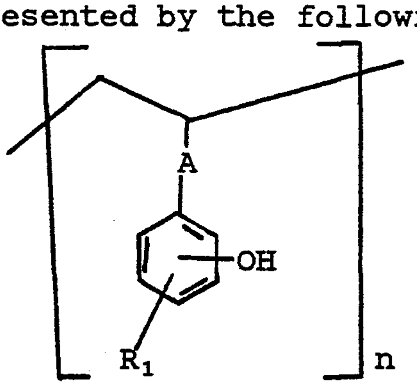

wherein A and $R_1$ have their previously assigned meanings, and is present in an amount of from about 10% to about 95% by weight of the polymer system in the composition, preferably from about 50% to about 95%, the novolak-type resin is present in an amount of from about 5% to about 90% by weight of the polymer system in the composition, preferably from about 5% to about 50%, the solvent is a mixture of ethylcellosolve acetate, butyl acetate, xylene and cyclohexanone, and the composition has a total solids content of from about 15% to about 40%.

The compositions are formed by adding the sensitizer, the phenolic resin and the novolak-type

resin to a solvent in which all three components are readily soluble. The order of addition is not critical. The solvent is preferably selected from the group consisting of aliphatic ketones, aliphatic esters, alkylene glycol monoalkyl ethers, dialkylene glycol monoalkyl ethers, alkylene glycol dialkyl ethers, and mixtures thereof. A particularly preferred class of aliphatic esters are the aliphatic alkylene glycol alkyl ethyl esters. More preferably, the solvent is selected from the group consisting of cyclohexanone, methylcellosolve acetate, ethylcellosolve acetate, butyl acetate and mixtures thereof. A particularly preferred solvent for use with deep UV compositions is a mixture of ethylcellosolve acetate, butyl acetate, and xylene. The choice of solvent will depend on the specific phenolic resin, novolak-type resin and sensitizer employed.

After the phenolic resin, the novolak-type resin and the sensitizer have been added to the solvent, the mixture is agitated until all solids are dissolved. The resultant resist solution is microfiltered, preferably using a millipore microfiltration system under about 30 pounds per square inch of pressure of nitrogen or other inert, oxygen-free ambient atmosphere.

Additives such as dyes, anti-striation agents, plasticizers, adhesion promoters, speed enhancers, and non-ionic surfactants may be added to the solution of the novolak resin, the phenolic resin and the sensitizer before the solution is filtered.

Dye additives useful with the negative resist compositions of the present invention include Methyl Violet 2B (C.I. No. 42535), Crystal Violet (C.I. No. 42555), Malachite Green (C.I. No. 42000), Victoria Blue B (C.I. No. 44045) and Neutral Rec (C.I. No. 50040) at 0.1 to 1.0 percent weight levels,

based on the combined weight of the novolak resin and the sensitizer. The dye additives may help provide increased resolution by inhibiting back scattering of light off the substrate.

Anti-striation agents may be used up to a five percent weight level, based on the combined weight of the novolak-type resin and the sensitizer.

Plasticizers which may be used include, for example, phosphoric acid tri-(β-chloroethyl)-ester; stearic acid; dicamphor; acetal resins; phenoxy resins; and alkyd resins at 1% to 10% weight levels, based on the combined weight of the novolak-type resin and the sensitizer. The plasticizers improve the coating properties of the material and enable the application to the substrate of a film that is smooth and of uniform thickness.

Adhesion promoters which may be used include, for example, β-(3,4-epoxy-cyclohexyl)-ethyltrimethoxysilane; p-methyl-disilane-methyl methacrylate; vinyltrichlorosilane; and γ-amino-propyl triethoxysilane up to a 4 percent weight level, based on the combined weight of the novolak-type resin and the sensitizer.

Speed enhancers that may be used include, for example, picric acid, nicotinic acid or nitro-cinnamic acid at a weight level of up to 20 percent, based on the combined weight of the novolak-type resin and the sensitizer. These enhancers tend to increase the solubility of the resist coating in both the exposed and unexposed areas, and thus they are used in applications where speed of development is the overriding consideration even though some degree of contrast may be sacrified. Thus while the unexposed areas of the resist coating will be dissolved more quickly by the developer, the speed enhancers will also cause a larger loss of resist coating from the exposed areas.

Non-ionic surfactants that may be used include, for example, nonylphenoxy poly(ethyleneoxy) ethanol; octylphenoxy (ethyleneoxy) ethanol; and dinonylphenoxy poly(ethyleneoxy) ethanol at up to 10 percent weight levels, based on the combined weight of novolak-type resin and the sensitizer.

The filtered resist composition can be applied to a substrate by any conventional method used in the resist art, including dipping, spraying, whirling and spin coating. When spin coating is employed, the percent total solids content is selected to provide coatings of the desired thickness given the type of spinning equipment utilized and the spin speed and the amount of time allowed for the spinning process.

The resist coatings produced by the above-described procedure are particularly suitable for application to thermally grown silicon/silicon dioxide-coated wafers such as are utilized in the production of microprocessors and other miniaturized integrated circuit components. An aluminum/aluminum oxide wafer can be used as well.

After the resist composition is coated onto the substrate, the substrate is baked at approximately 100° to 105°C until substantially all the solvent has evaporated and only a thin coating of the resist, on the order of a micron in thickness, remains on the substrate. The coated substrate can then be exposed, using ultra violet radiation or an electron beam, in any desired exposure pattern produced by use of suitable masks, negative stencils, templates, or the like. The negative resists can be exposed using commercially available equipment, for example, a Perkin-Elmer 1:1 Projection Micralign 500 Model which can be set to operate in the near (about 400 to about 350 nm), mid (about 350 to about 280 nm), or deep (about 280 to about 220 nm) ultra violet ranges of the spectrum.

The exposed negative resist-coated substrates are then substantially immersed in developing solution in, for example, a Teflon tank. The solution is preferably agitated, for example, by nitrogen burst agitation. The substrates are allowed to remain in the developer until all, or substantially all, of the negative resist coating has been dissolved from the unexposed areas.

The negative resist compositions of the present invention form negative resists which are soluble in aqueous alkaline developers and which can be developed with positive resist developers. The developer formulation is not critical and typical of the developers useful with the negative resists of the present invention is WX-402, an aqueous alkaline positive resist developer manufactured by Philip A. Hunt Chemical Corporation.

Typical development conditions are 23±2°C, with the development time depending largely on the pre-bake temperature and time, exposure energy, developer strength and the developer mode such as spray, puddle, nitrogen burst submersion or mechanical agitation. For example, under mild (magnetic bar) agitation, using 50% WX-402 developer in the immersion mode, developing times typically range between about 70 and about 150 seconds for 1 micron coatings pre-baked at about 75° to about 105°C for about 20 to about 50 minutes.

In general, increasing the exposure energy requires increasing the development time in order to wash out resist in fine window geometries. Different development times are required to remove identical resist thicknesses at different pre-bake temperatures and the exposure energy employed is related to the unexposed resist development times. Increasing the exposure energy as well as employing high pre-bake temperatures results in slower development rates and provides greater development contrast.

With the deep ultra violet compositions, the imaged resist surface receives greater exposure energy than the resist bottom and therefore the top surface of the image becomes sufficiently insoluble in the developer to retain a high film thickness after development. The underlying resist is protected from attack by the developer. However, as the development of unexposed resist progresses, the side walls of the exposed image progressively develop at a greater rate than that of the upper layers of the resist. Increased development times result in further erosion of the resist base and produce negatively sloped resist walls. Most common deep ultra violet positive resist systems provide sloped profiles caused by the internal absorption of the surface layers of the resist.

By selecting a specific exposure energy and development time, exact mask reproduction of 1 micron and greater is possible with the deep ultra violet compositions of the present invention. Reducing or increasing the exposure energy accompanied by suitable adjustments in the development times produces smaller or larger resist line widths than the mask window dimensions.

After removal of the coated wafers from the developing solution, a post-development heat treatment or bake may be employed to increase the adhesion and chemical resistance to etching solutions and other substances. The post-development heat treatment can be effected by oven baking of the coating and substrate at a temperature below the softening point of the coating. In industrial applications, particularly in the manufacture of microcircuitry units on silicon/silicon dioxide-type substrates, the developed substrates are typically treated with a buffered, hydrofluoric acid-based etching solution. The negative resists of the present

invention are resistant to acid-based etching solutions and provide effective protection for the resist-coated areas of the substrate.

The negative resists of the present invention provide greater resolution capabilities than the cyclized rubber-based negative resist systems, provide high-speed deep ultra violet resists, exhibit high plasma etch resistance and exhibit high thermal deformation resistance. The deep ultra violet compositions exhibit excellent step coverage properties. Uniform image resist line widths can be produced which do not exhibit any signs of "necking" at the edge of steps. The deep ultra violet negative resists of the present invention are capable of producing submicron geometries and resist lines having vertical side walls and an approximate width of at least 0.4 micron can be produced.

Examples

The following examples present illustrative but non-limiting embodiments of the present invention. Comparative examples are also provided. Resist film thicknesses in the following examples were measured using a Sloan Dektak Profilometer. The resist coatings in the following examples were exposed using either a Perkin-Elmer 1:1 Projection Micralign 500 Model which could be set to operate in the near, mid or deep ultra violet ranges of the spectrum, or a Kaspar Instruments contact exposure unit Model 2001 retrofitted for deep ultra violet with an Optical Associates Inc. Model 23T light source.

Example 1

9.27g of 3,3'-diazidodiphenyl sulfone were added to 104g of a 30% solids polyvinyl phenol solution of a 10,000 $\bar{M}w$ polyvinyl phenol (hereinafter

"PVP") in an 80:10:10 ethylcellosolve acetate:butyl acetate:xylene solvent (hereinafter "the 80:10:10 solvent") and were combined with 39.25g of cyclohexanone and 5.88g of a novolak resin prepared by reacting 60% m-cresol and 40% p-cresol as set forth in U.S. Patent 4,377,631. The resulting composition contained 26.77% total solids of which 19.53% were sensitizer, 12.76% were novolak resin and 67.71% were PVP. The solvent comprised 57.7% of the 80:10:10 solvent and 42.3% of cyclohexanone. The composition was microfiltered and two wafers were coated with the solution one at 3,000 rpm resulting in a 13,200 Å coating and another at 4,000 rpm resulting in an 11,440 Å coating. The coatings were soft baked at 85 to 90°C for 30 minutes. The wafers were exposed to ultra violet light (260-240 nm) and then developed in a metal ion-containing aqueous alkaline developer (LSI developer available from Philip A. Hunt Chemical Corporation). Clean development was obtained with good adhesion.

Example 2 (Comparative)

1.45g of 3,3'-diazidodiphenyl sulfone were dissolved in 19.35g of a 30% solids polyvinyl phenol solution of an 8,300 $\bar{M}w$ PVP in the 80:10:10 solvent and 9.674g of cyclohexanone were added. The resulting composition contained 25% total solids with a sensitizer weight ratio to total solids of about 20% in a solvent comprising 58.3% of the 80:10:10 solvent and 41.7% of cyclohexanone. Four wafers were coated with the composition; two at 5,000 rpm and two at 4,500 rpm. After spinning, the wafers were dried for about 30 minutes at a temperature between 80 and 100°C. One of the 5,000 rpm wafers was exposed to ultra violet light (400 nm) for 40 seconds and then developed in a metal ion-containing aqueous alkaline developer (a 27% solution of LSI developer). The coating washed out in about 25 seconds. The second 5,000 rpm wafer was exposed for 60 seconds and then developed in a 20.4% solution of LSI developer. Excessive film loss was observed and the coating was almost entirely washed out. The two 4,500 rpm wafers were exposed to ultra violet light (310 nm, 11.5 m.wt./$cm^2$); one for 10 seconds and the other for 30 seconds followed by development in 17% and 20.4%, respectively, LSI developer. Severe lifting of the coating was observed in each case and the coating wrinkled and fell off.

Example 3

Representative and comparative compositions were prepared having the formulations summarized in Table 1. Unprimed wafers were coated with composi tions A, B, C and D and the coatings pre-baked at 85 to 90°C for 30 minutes after which they were exposed through a multi-density mask using ultra violet radiation (260 nm) at an intensity of 3.6 m.wt./$cm^2$ and then developed, all as summarized in Table 2.

The effect of the pre-bake temperature on the performance of the resist was evaluated for compositions A and D. Wafers were coated with the compositions and then pre-baked for 30 minutes at either

TABLE 1

Composition

| | A | B | C | D | E[1] | F[2] | G[3] |
|---|---|---|---|---|---|---|---|
| Wt.% Sensitizer[4] (in solids) | 17.28 | 19.53 | 20 | 20 | 19.99 | 19.9 | 19.99 |
| Wt.% PVP (in solids) | 67.71[5] | 67.71 | 70[5] | 70[5] | 80.01 | 80.1 | 80.01 |
| Wt.% Novolak[8] (in solids) | 15.00 | 12.76 | 10 | 10 | 0 | 0 | 0 |
| Total % solids | 25.00 | 26.77 | 27 | 27 | 23.81 | 25.01 | 25.02 |
| Solvent: % 80:10:10 solvent/ % cyclohexanone | 52.7/ 47.3 | 72.8/ 53.2 | 60.87/ 39.13 | 60.87/ 39.13 | 58.33/ 41.67 | 62.29/ 37.71 | 43.61/ 56.39 |

1 Comparative.

2 Comparative.

3 Comparative.

4 3, 3'-diazidodiphenylmethylene sulfone.

5 10,000 $\overline{M}w$.

6 7,400 $\overline{M}w$.

7 4,000 $\overline{M}w$.

8 The novolak resin described in example 1.

Table 2

| Composition | Spin Speed (rpm) | Film Thickness (μ) | Wafer Number | Exposure Time (Sec.) | Developer/ % Concentration | Development Time (Sec.) | %T for Zero Film Thickness | Comments |
|---|---|---|---|---|---|---|---|---|
| B | 3000 | 1.32 | 1 | 10 | LSI[1]/30 | 60 | 14 | |
| B | 4000 | 1.144 | 2 | 10 | LSI/30 | 60 | 14 | |
| B | 4000 | 1.144 | 3 | 10 | LSI/30 | 45 | 5 | |
| B | 4000 | 1.144, | 4 | 10 | LSI/30 | 40 | 5 | |
| B | 4000 | 1.144 | 5 | 10 | LSI/25 | 70-75 | 5 | |
| B | 4000 | 1.144 | 6 | 15 | LSI/25 | 75 | 5 | |
| B | 4000 | 1.144 | 7 | 10 | LSI/30 | 60 | 14 | |
| B | 4000 | 1.144 | 8 | 10 | LSI/25 | (35) | 5 | |
| | | | | | Intensity = 3.55 m.wt./$cm^2$ (260nm) | | | |
| B | 4000 | 1.14 | 1 | 10 | LSI/30 | 45 | Resolution Mask | |
| B | 4000 | 1.14 | 2 | 2.5 | LSI/30 | 45 | " | All appeared to show over-exposure for 1μ lines (best is 2.5 seconds) |
| B | 4000 | 1.14 | 3 | 3.5 | LSI/30 | 45 | " | |
| B | 4000 | 1.14 | 4 | 4.5 | LSI/30 | 45 | " | |

1 A metal ion-containing aqueous alkaline developer available from Philip A. Hunt Chemical Corporation.

Table 2 (cont'd)

| Compo-sition | Spin Speed (rpm) | Film Thickness (μ) | Wafer Number | Exposure Time (Sec.) | Developer/ % Concen-tration | Development Time (Sec.) | %T for Zero Film Thickness | Comments |
|---|---|---|---|---|---|---|---|---|
| B | 4000 | 1.14 | 5 | 10 | LSI/30 | 45 | 5 | |
| B | 4000 | 1.14 | 6 | 10 | LSI/25 | 75 | 5 | |
| | | | | | Intensity = 3.6 m.wt./$cm^2$ (250nm) | | | |
| B | 4000 | 1.16 | 9 | 10 | LSI/30 | 45 | 5 | |
| B | 4000 | 1.16 | 10 | 10 | MIF[2]/25 | ~30 | 5/10 | |
| B | 4000 | 1.16 | 11 | 1.5 | LSI/30 | 45 | Resolution Mask | Slightly under exposed, still no improved resolution at 1μ |
| A | 4000 | 0.96 | 7 | 10 | LSI/30 | 45 | 20 | Excessive film loss at 100%T |
| A | 4000 | 0.96 | 8 | 10 | LSI/25 | 60 | 5 | Some film loss at 100%T |

2 A metal ion-free aqueous alkaline developer available from Philip A. Hunt Chemical Corporation.

Table 2 (cont'd)

| Composition | Spin Speed (rpm) | Film Thickness (μ) | Wafer Number | Exposure Time (Sec.) | Developer/ % Concentration | Development Time (Sec.) | %T for Zero Film Thickness | Comments |
|---|---|---|---|---|---|---|---|---|
| C | 4000 | 1.12 | 1 | 10 | LSI/25 | 60 | 5 | Slight film loss at 100%T, areas passable |
| C | 4000 | 1.12 | 2 | 10 | LSI/25 | 60 | 5/10 | No film loss |
| C | 4000 | 1.12 | 3 | 10 | LSI/20 | 150-190 | 5 | No film loss |
| C | 4000 | 1.12 | 4 | 10 | MIF/20 | 90 | ~12 | Slight film loss at 100%T |
| C | 4000 | 1.12 | 5 | 10 | MIF/20 | 80 | ~10 | Acceptable |
| C | 4000 | 1.12 | 6 | 10 | MIF/25 | 25 | ~12 | Slight film loss at 100%T |
| C | 4000 | 1.12 | 7 | 10 | LSI/30 | 35 | 10/12 | Slight film loss at 100%T |
| C | 4000 | 1.12 | 8 | 10 | LSI/30 | 45 | 18 | Excessive film loss at 100%T |

Intensity =
3.4 m.wt./$cm^2$
(260nm)

Table 2 (cont'd)

| Composition | Spin Speed (rpm) | Film Thickness (μ) | Wafer Number | Exposure Time (Sec.) | Developer/ % Concentration | Development Time (Sec.) | %T for Zero Film Thickness | Comments |
|---|---|---|---|---|---|---|---|---|
| D | 4000 | 1.06 | 1 | 10 | LSI/30 | 25 | 14/16 | Excessive film loss at 100%T |
| D | 4000 | 1.06 | 2 | 10 | LSI/25 | 43 | 5 | Slight film loss |
| D | 4000 | 1.06 | 3 | 10 | LSI/20 | 120 | 12/13 | Acceptable |
| D | 4000 | 1.06 | 4 | 15 | MIF/20 | 55 | ~10 | Acceptable |

100° to 105°C or 125° to 130°C, then exposed through a multi-density mask using ultra violet radiation at an intensity of 3.3 to 3.5 m.wt./$cm^2$ and then developed, all as summarized in Table 3.

For comparative purposes, primed and unprimed wafers were coated with comparative compositions E, F and G at 4,000 rpm and pre-baked at 85° to 90°C for 30 minutes after which they were exposed through a multi-density mask using ultra violet radiation (260 nm) at an intensity of 3.65 m.wt./$cm^2$, and then developed after which they were rinsed for one minute in water acidified with acetic acid followed by a one minute rinse in water, all as summarized in Table 4.

Example 4 (Comparative)

A comparative composition was prepared containing 27% solids by dissolving 5.4g of 3,3'-diazidodiphenyl sulfone in a solvent comprising 36.5g of ethylcellosolve acetate and 36.5g of cyclohexanone and then adding 21.6g of the novolak resin described in example 1. The composition contained 20% sensitizer and 80% novolak resin, by weight of the total solids. The composition when coated on a wafer, pre-baked and exposed to deep ultra violet radiation (260 nm) provided poor imaging but tended to provide positive imaging with strong developer.

Example 5 (Comparative)

A composition was prepared by dissolving 1g of 2,6-di(4'-azidobenzal)-4-methylcyclohexanone in 27g of cyclohexanone followed by addition of 4g of an 8,300 $\bar{M}w$ polyvinyl phenol. The composition was microfiltered through a 0.2 micron pall/prefilter

Table 3

| Composition | Pre-bake Temperature (°C) | Wafer Number | Exposure Time (Sec.) | Developer/% Concentration | Development Time (Sec.) | %T for Zero Film Thickness | Comments |
|---|---|---|---|---|---|---|---|
| A | 100 to 105 | 1 | 10 | LSI/20 | 195 | 5 | |
| A | 100 to 105 | 2 | 10 | LSI/25 | 50 | 12 | Some film loss |
| A | 100 to 105 | 3 | 10 | LSI/22.5 | 95 | 10/12 | Slight film loss |
| A | 100 to 105 | 4 | 20 | MFI/20 | 90 | 5 | |
| A | 125 to 130 | 5 | 10 | LSI/22.5 | 90 to 95 | 1 | |
| A | 125 to 130 | 6 | 10 | LSI/25 | 50 | 5 | Slight film loss |
| A | 125 to 130 | 7 | 10 | MFI/20 | 100 | 5 | |
| A | 125 to 130 | 8 | 20 | MFI/20 | 100 | 1 | |
| D | 100 to 105 | 9 | 10 | MFI/20 | 60 | 5 | |
| D | 125 to 130 | 10 | 10 | MFI/20 | 80 | 5 | |

Table 4

| Composition | Film Thickness (Å) | PVP ($\bar{M}_w$) | Wafer Number | Primed | Unprimed | Exposure Time (Sec.) | LSI (%Concentration) | Development Time (Sec.) | %T for Zero Film Thickness | Comments |
|---|---|---|---|---|---|---|---|---|---|---|
| E | 9,000 | 10,000 | 1 | -* | X** | 10 | 25 | 75 | 14 | Severe cracking and lifting |
| E | 9,000 | 10,000 | 2 | - | X | 10 | 30 | 45 | 14 | Severe cracking and lifting |
| E | 9,000 | 10,000 | 3 | X | - | 10 | 30 | 60 | 18 | Poor profiles |
| E | 9,000 | 7,400 | 4 | - | X | 10 | 25 | 60 | 22/25 | Lifting and cracking |
| F | 9,000 | 7,400 | 5 | - | X | 10 | 25 | 35 | 14 | - |
| F | 9,000 | 7,400 | 6 | X | - | 10 | 30 | 30 | 22 | - |
| G | 9,250 | 4,000 | 7 | - | X | 10 | 25 | 40 | 35 | Some developer attack in spots, blistering or undercutting |
| G | 9,250 | 4,000 | 8 | - | X | 10 | 25 | 30 | 30 | - |
| G | 9,250 | 4,000 | 9 | X | - | 10 | 20 | 45 | 20-18 | - |
| G | 9,250 | 4,000 | 1 | X | - | 10 | 20 | 45 | 18-20 | Optimum resolution of these coatings around 30-35%T |
| G | 9,250 | 4,000 | 2 | X | - | 10 | 20 | 35 | 14 | |
| G | 9,250 | 4,000 | 3 | X | - | 10 | 20 | 30 | 12 | |
| G | 9,250 | 4,000 | 4 | X | - | 10 | 20 | 30 | 12 | |
| G | 9,250 | 4,000 | 5 | X | - | 10 | 20 | 25 | 5 | |

* No.

** Yes.

and had a total solids content of 15.6%. The composition was used to coat five 2-inch primed wafers at 3,000 rpm. The coated wafers were dried at 100° to 105°C resulting in 0.56 micron film thicknesses. The wafers were exposed to near ultra violet radiation (400 to 350 nm) through a multi-density mask and then developed, all as summarized in Table 5. A visible, colored image was observed after exposure and prior to development.

Example 6

A composition was prepared by dissolving 0.5g of 2,6-di-(4'-azidobenzal)-4-methylcyclohexanone in about 25g of cyclohexanone followed by the addition of 4g of a 3,000 $\bar{M}w$ polyvinyl phenol. 0.4g of the novolak resin described in example 1 were then added. The sample was then microfiltered and had a total solids content of 16.3%. Six unprimed wafers were coated at 3,000 rpm with the solution and then pre-baked at 100° to 105°C for 30 minutes resulting in film thicknesses of 0.792 micron. The wafers were exposed using a multi-density mask on a contact exposure unit using ultra violet radiation (380 nm) at 3.2 m.wt./$cm^2$ intensity and then developed, all as summarized in Table 6.

Example 7

A composition was prepared by dissolving 10.8g of 3,3'-diazidodiphenyl sulfone in 57.8g of cyclohexanone with slight warming and then adding 5.4g of the novolak resin described in example 1 were then added followed by 126g of a 30% solids polyvinyl phenol (10,000 $\bar{M}w$) solution in ethylcellosolve acetate, with mixing until dissolved. The solution contained 27% total solids of which 70% were PVP, 10% were novolak resin and 20% were sensitizer. The solvent mixture comprised, by weight,

Table 5

| Wafer No. | Exposure Time (Sec.) | MIF Developer (% Concentration) | Development Time (Sec.) | Results |
|---|---|---|---|---|
| 1 | 10 | 20 | 60 | No development. |
| | | 25 | 45 | Some film loss occurred. Negative image. |
| 2 | 10 | 25 | 40 | Incomplete development but appears to be high resolution. |
| 3 | 15 | 25 | 60 | Complete development, high resolution at 35% to 60% T. |
| 4 | 30 | 25 | 45 | Incomplete development. |
| 5 | 30 | 25 | 60 | High resolution at 50% and 60% T. Complete development. |

Table 6

| Wafer No. | Exposure Time (Sec.) | MIF Developer (% Concentration) | Development Time (Sec.) | % T for Zero Film Thickness | Comments |
|---|---|---|---|---|---|
| 1 | 30 | 20 | 60<br>60 | - | Incomplete development of unexposed areas |
| 2 | 30 | 27.5 | 60 | 14% | Clean development of unexposed areas |
| 3 | 20 | 25 | 60 | <1% | Complete development in unexposed areas |
| 4 | 20 | 30.0 | 60 | 50% | Considerable film loss in exposed areas |
| 5 | 10 | 25 | 60 | <1% | Complete development in most unexposed areas |
| 6 | 10 | 25 | 60 | <1% | Incomplete development in unexposed areas |

60.4% ethylcellosolve acetate and 39.6% cyclohexanone. The solution was microfiltered before use. A portion of the solution was used to coat wafers which when exposed to ultra violet radiation (280 to 210 nm) through a mask and developed for 70 seconds with a 20% solution of a metal ion-free aqueous alkaline developer and examined by scanning electron microscopy exhibited good resist profiles. The 1 micron as well as the 0.6 to 0.75 micron lines were well resolved.

Example 8

Four compositions were prepared as follows. Composition H was prepared by adding to 150g of the composition prepared in example 7, 23 microliters of a commercially available solution of an anti-striation agent. Composition I was prepared by combining 8.125g of a 30,000 $\bar{M}w$ polyvinyl phenol, 1.875g of the novolak resin described in example 1, 2.5g of 4,4'-diazidodiphenyl methane and 25g of cycloxehanone. The solution had a total solids content of 25% of which 65% were PVP, 15% were novolak resin and 20% were sensitizer. Composition J was prepared by combining 8.775g of a 13,000 $\bar{M}w$ polyvinyl phenol, 2.025g of the novolak resin described in example 1, 2.7g of 4,4'-diazidodiphenyl methane and 23g of cyclohexanone. The solution contained 27% total solids of which 65% were PVP, 15% were novolak resin and 20% were sensitizer. Composition K was identical to the formulation prepared in example 7.

Wafers were coated with compositions H, I, J and K at a spin speed of 7,000 rpm and the coatings pre-baked at 100° to 105°C for 30 minutes after which they were exposed through either a multi-density mask or a resolultion mask using ultra violet radiation at an intensity of 3.95 m.wt./$cm^2$ (260 nm) and then developed, all as summarized in Table 7.

Table 7

| Composition | Wafer Number | Film Thickness (μ) | Exposure Time (Sec.) | Mask | MIF Developer (% Concentration) | Development Time (Sec.) | Clean Development | | Comments |
|---|---|---|---|---|---|---|---|---|---|
| | | | | | | | large areas | small areas | |
| K | 1 | 0.96 | 10 | MD[1] | 20 | 70 | X[3] | X | |
| K | 2 | 0.96 | 10 | MD | 20 | 60 | X | -[4] | |
| K | 3 | 0.96 | 4 | RES[2] | 20 | 70 | X/- | X/- | Crystals on coating; good resolution, sharp image |
| H | 4 | 0.99 | 10 | MD | 20 | 70 | X | X | |
| H | 5 | 0.99 | 10 | MD | 20 | 60 | X | - | Areas between small equi-spaced bars were not clean |
| H | 6 | 0.99 | 4 | RES | 20 | 70 | X | X | Excellent resolution and sharp images |
| I | 7 | 2.35 | 20 | MD | 25 | 90 | X/- | - | |
| I | 8 | 2.35 | 20 | MD | 25 | 100 | X/- | X | |
| I | 9 | 2.35 | 5 | RES | 25 | 100 | X/- | X | Good resolution. Some film loss in small geometries; adhesion problem, possibly underexposed; large areas not cleanly developed |

---

1 Multi-density mask.

2 Resolution mask.

3 Yes.

4 No.

Table 7 (cont'd)

| Composition | Wafer Number | Film Thickness (μ) | Exposure Time (Sec.) | Mask | MIF Developer (% Concentration) | Development Time (Sec.) | Clean Development | | Comments |
|---|---|---|---|---|---|---|---|---|---|
| | | | | | | | large areas | small areas | |
| I | 10 | 2.35 | 7 | RES | 27 | 85 | X/- | X | Good resolution. Some film loss in small geometries, adhesion problem, possibly underexposed; large areas not cleanly developed |
| J | 11 | 2.825 | 20 | MD | 20 | 195 | X/- | - | Poor adhesion |
| J | 12 | 2.825 | 20 | MD | 25 | 85 | X/- | X/- | Poor adhesion |
| J | 13 | 2.825 | 30 | MD | 25 | 90 | X/- | X | Poor adhesion |
| J | 14 | 2.825 | 5 | RES | 25 | 90 | X/- | X | Underexposed; large areas uncleaned; good resolution but small geometries were washed out |
| J | 15 | 2.825 | 8 | RES | 27 | 75 | X/- | X | |

Compositions I and J appeared to exhibit signs of underexposure due to very high film thickness which particularly affected the bottom of exposed geometries to cause adhesion failures. Composition H appeared to show less striation than composition K as evidenced by the developed areas of the thin films where striation usually causes an uneven development due to uneven exposures.

Example 9

Compositions L and M were prepared having the components in the amounts indicated in Table 8.

Table 8

| L | Component | M |
|---|---|---|
| 17.56 | % Total solids | 17.56 |
| Cyclohexanone | Solvent | Cyclohexanone |
| 4,4'-diazidodiphenyl ether | Sensitizer | 4,4'-diazidodiphenyl methane |
| 10.2 | % Sensitizer, in solids | 10.2 |
| 81.6 | % PVP (10,000 $\bar{M}w$), in solids | 81.6 |
| 8.16 | % Novolak resin(as described in example 1), in solids | 8.16 |

Wafers were coated with the compositions at 3,000 rpm, pre-baked at 100°C for 30 minutes, exposed to ultra violet radiation (260 nm) through either a multi-density (MD) mask or a resolution (RES) mask and then developed, all as summarized in Table 9. Wafer 3 showed the best resolution but appeared to have lost some film, perhaps due to over-development. Wafers 1 and 5 appeared to have been underdeveloped. Wafers 6 and 7 both showed high levels of underdeveloped spots of resist in unexposed areas and wafer 8 showed some film thickness loss and signs of overexposure.

Example 10

Compositions N, O, P and Q were prepared as follows. Composition N was prepared by diluting 18.61g of composition I prepared in example 8 with 2.54g of butyl acetate to provide a solution having 22% total solids. Composition O was prepared by diluting 12.73g of sample J prepared in example 8 with 2.216g of butyl acetate to provide a solution having 23% total solids. Composition P was prepared by diluting 18.73g of composition N with 1.873g of butyl acetate to provide a solution having 20% total solids. Composition Q was prepared by diluting 12.57g of composition O with 1.8855g of butyl acetate to provide a solution having 20% total solids. Each composition was coated on wafers at two different spin speeds and a development time for complete film removal was determined. The results are summarized in Table 10.

Because the coatings showed severe striations, a very small amount of an anti-striation agent was added to each composition and wafers coated with the modified compositions produced coatings without striations. Compositions P and Q containing the anti-striation agent were used to coat primed 3-inch

Table 9

| Wafer Number | Composition | Film Thickness (μ) | Exposure Time (Sec.) | Io, m.wt./$cm^2$ | Development Time (Sec.) | Developer/ % Concentration | Mask |
|---|---|---|---|---|---|---|---|
| 1 | L | 0.8 | 3 | 4.05 | 165 | MIF/15 | RES |
| 2 | L | 0.8 | 10 | 4.7 | 105 | MIF/15.7 | MD |
| 3 | L | 0.8 | 6 | 4.05 | 50 | MIF/20 | RES |
| 4 | L | 0.8 | 10 | 4.7 | 20 | MIF/25 | MD |
| 5 | M | 0.7 | 4 | 4.05 | 150 | MIF/15 | RES |
| 6 | M | 0.7 | 10 | 4.7 | 120 | MIF/15.7 | MD |
| 7 | M | 0.7 | 10 | 4.7 | 90 | MIF/15.7 | MD |
| 8 | M | 0.7 | 8 | 4.05 | 35 | MIF/20 | RES |

Table 10

| Composition | Film Thickness (μ) | RPM | Development Time For Complete Film Removal (Sec.) MIF, 25% Conc. | MIF, 27% Conc. | MIF, 30% Conc. |
|---|---|---|---|---|---|
| N | 1.9 | 4,000 | - | 105-115 | - |
| N | 1.57 | 7,000 | - | - | 50-70 |
| P | 1.55 | 4,000 | - | 75-90 | - |
| P | 1.12 | 7,000 | - | - | 37-50 |
| O | 2.25 | 4,000 | - | 65-85 | - |
| O | 1.62 | 7,000 | 60-80 | - | - |
| Q | 1.4 | 4,000 | - | 45-55 | - |
| Q | 1.02 | 7,000 | 45-57 | - | - |

wafers. The wafers were coated at 7,550 rpm for 30 seconds and were then pre-baked at 101° to 105°C for 30 minutes. The wafers were exposed to ultra violet light (260 nm) through a resolution mask at an intensity of 3.8 m.wt./cm . The wafers were then developed and evaluated, all as summarized in Table 11. The large unexposed areas of the resist consistently showed large numbers of undeveloped resist areas and in some cases also showed unwashed residual spots.

Example 11

Composition R was prepared by dissolving 11.2g of 4,4'-diazidodiphenyl methane in 112.5g of cyclohexanone followed by the addition of 112.5g of ethylcellosolve acetate, 48.75g of a 30,000 $\bar{M}w$ polyvinyl phenol and 15g of the novolak resin described in example 1 to provide a solution having 25% total solids. This composition produced film thicknesses of 1.06 microns at 4,000 rpm, 0.88 micron at 5,000 rpm and 0.78 micron at 7,000 rpm when the coatings were dried for 30 minutes at 100° to 105°C.

Seven primed wafers were coated with composition R and then pre-baked at 100° to 105°C for 30 minutes. The wafers were exposed to ultra violet radiation at an intensity of 3.5 m.wt./$cm^2$ (260 nm) through a resolution mask and then developed and evaluated, all as summarized in Table 12.

Example 12

Compositions S, T, U, V, W and X were prepared as 27% total solids solutions in cycloxehanone, as summarized in Table 13.

Table 11

| Composition | Film Thickness (μ) | Wafer Number | Exposure Time (Sec.) | MIF Developer, % Concentration | Development Time (Sec.) | Resolution[1] | Development of Unexposed Areas: Small Areas | Development of Unexposed Areas: Large Areas |
|---|---|---|---|---|---|---|---|---|
| P | 1.08 | 1 | 8 | 30 | 60 | good | clean | not clean |
| P | 1.08 | 2 | 6 | 27 | 60 | very good | clean | not clean |
| P | 1.08 | 3 | 4 | 27 | 60 | excellent | clean | not clean |
| Q | 1.0 | 4 | 7 | 25 | 60 | very good | clean | not clean |
| Q | 1.0 | 5 | 5 | 25 | 53 | very good | clean | not clean |

---

1 Resolution:

excellent = all geometries were sharply defined, no apparent film loss or edge erosion as well as smallest (1 μ) bars were cleanly developed.

very good = all geometries (except 1 μ -- smallest) were well defined and no apparent film loss occurred. (1 μ) bars could show some over exposure -- evident by uncleanly developed spaces between bars.

good = similar to above (very good) -- except that smaller geometries (1 μ) and (2 μ) may show some distortion and adhesion problem due to over development in case of wafer No. 1.

Table 12

| Wafer Number | Exposure Time (Sec.) | MIF Developer (% Concentration) | Development Time (Sec.) | Comments |
|---|---|---|---|---|
| 1 | 6 | 25 | 60 | Very underdeveloped or overexposed |
| 2 | 4 | 25 | 70 | Fine resolution, background (unexposed area) relatively clean |
| 3 | 4 | 27 | 60 | Good resolution, slightly underdeveloped; background not too clean |
| 4 | 4 | 20* | 100 | Good resolution, looks underdeveloped or overdeveloped |
| 5 | 4 | 24.7** | 60 | Good resolution but underdeveloped; background dirty |
| 6 | 8 | 24.7** | 60 | Grossly overexposed and underdeveloped; undeveloped resist particles in background |
| 7 | 4 | 27 | 50 | Rinsed in 4% surfactant solution, then in water; fine resolution, underdeveloped and a large number of undeveloped resist particles |

* 2% of a surfactant was added to the developer.

** 1.88% of a surfactant was added to the developer.

Table 13

| Composition | % PVP (30,000 $\bar{M}w$), in solids | % Novolak resin, in solids $N_1$[1] | $N_2$[2] | % Sensitizer,[3] in solids | Film Thickness, μ (5000 RPM) |
|---|---|---|---|---|---|
| S | 70 | 10 | - | 20 | 1.28 |
| T | 70 | - | 10 | 20 | 1.3 |
| U | 30 | 60 | - | 10 | 1.06 |
| V | 30 | - | 60 | 10 | 1.29 |
| W | 25 | 55 | - | 20 | 0.79 |
| X | 25 | - | 55 | 20 | 0.95 |

1 A high dissolution rate novolak resin.

2 A low dissolution rate novolak resin.

3 4,4'-bisazidodiphenyl methane.

## Example 13

Compositions AA, BB and CC were prepared as 27% total solids solutions in cycloxehanone. Composition AA contained, by weight of the total solids, 15% of

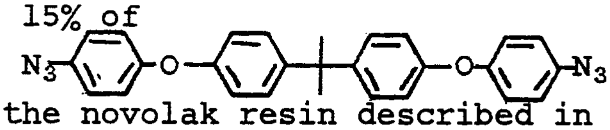 ,

35% of the novolak resin described in example 1, and 50% of a 30,000 $\bar{M}w$ polyvinyl phenol. Composition BB contained, by weight of the total solids, 10% of

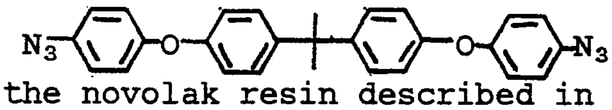 ,

30% of the novolak resin described in example 1 and 60% of a 30,000 $\bar{M}w$ polyvinyl phenol. Composition CC contained, by weight of the total solids, 5% of

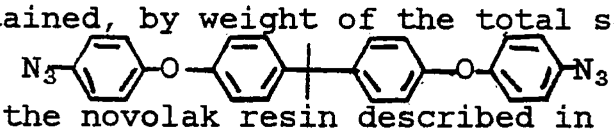 ,

30% of the novolak resin described in example 1, and 65% of a 30,000 $\bar{M}w$ polyvinyl phenol. The compositions were coated on wafers, pre-baked at 100° to 105°C for 30 minutes, exposed to ultra violet light (260 nm) through a mask, developed and evaluated, all as summarized in Table 14.

## Example 14

A composition was prepared by combining 158.76g of a 24,000 $\bar{M}w$ polyvinyl phenol as a 30% solution in the 80:10:10 solvent (529.2g total of 80:10:10 solvent plus PVP) with 63g of the novolak resin described in example 1, 30.3g of

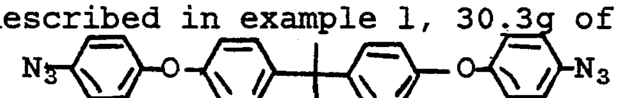 ,

and 277.7g of the 80:10:10 solvent. The solution contained 28% total solids of which 63% were the PVP, 25% were the novolak resin and 12% were the sensitizer. The solution had a viscosity of 38.8 cps. The sample was microfiltered through a 0.45 micron pall/prefilter, then 570 microliters of a commercially available anti-striation agent were added and then

Table 14

| Composition | Wafer Number | Developer[1] (% Concentration) | Development Time (Sec.) | Exposure Time (Sec.) RES[2] | MD[3] | Comments |
|---|---|---|---|---|---|---|
| AA | 1 | 50 | 42 | - | 5 | $\%T_0$=10 %T≧35 no reticulation |
| | 2 | 50 | 45 | - | 5 | =12 ≧30 |
| | 3 | 45 | 120 | - | 5 | = 5 ≧25 |
| | 4 | 50 | 45 | 4 | - | Overexposed or underdeveloped |
| | 5 | 45 | 120 | 4 | - | Overexposed or underdeveloped |
| | 6 | 50 | 45 | 3 | - | Overexposed or underdeveloped |
| | 7 | 45 | 120 | 3 | - | Overexposed or underdeveloped |
| BB | 1 | 50 | 45 | - | 5 | $\%T_0$=14 %T≧35 no reticulation |
| | 2 | 50 | 40 | - | 5 | =10 ≧35 |
| | 3 | 45 | 120 | - | 5 | =10 ≧35 cleaned out in 105 seconds |
| | 4 | 50 | 45 | 4 | - | Overexposed or underdeveloped |
| | 5 | 45 | 120 | 4 | - | Overexposed or underdeveloped |
| | 6 | 50 | 45 | 3 | - | |
| | 7 | 45 | 120 | 3 | - | Broken chips on borders of imaged bars |

Table 14 (cont'd)

| Composition | Wafer Number | Developer[1] (% Concentration) | Development Time (Sec.) | Exposure Time (Sec.) RES[2] | MD[3] | Comments |
|---|---|---|---|---|---|---|
| CC | 1 | 50 | 35 | - | 5 | Excessive film loss. $T_0$=22/40% |
| | 2 | 45 | 55 | - | 5 | High film loss. $T_0$ approximately 20% |
| | 3 | 42 | 90 | 4 | - | Narrow lines; 1 μ washed out; attack on resist surface |
| | 4 | 42 | 70 | 3 | - | Fine resolution (overdeveloped/ underexposed); some film loss. |

1 WX-402, a metal ion-free aqueous alkaline developer available from Philip A. Hunt Chemical Corporation.

2 Resolution mask.

3 Multi-density mask.

the solution was filtered through a 0.2 micron pall/ prefilter.

Example 15

A composition was prepared by combining 365.8g of a 30% by weight solution of the novolak resin described in example 1, 921.6g of a 30% polyvinyl phenol solution (a 1:1 mixture of a 24,000 $\bar{M}w$ PVP and a 27,000 $\bar{M}w$ PVP), 52.7g of

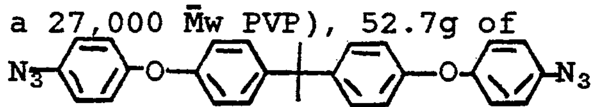 ,

and 415.7g of the 80:10:10 solvent. 1.25 ml of a commercially available anti-striation agent were then added. The solution was then microfiltered. The resulting solution comprised 6.25 weight % novolak resin solids, 15.75 weight % PVP solids, 3.00 weight % sensitizer solids, and 75.00 weight % solvent. For every 100g of these four components, 0.065 weight % of the anti-striation agent was added. The ultraviolet absorption of this composition was determined and it was found that the composition was very transparent at 700 to 550 nm and rapidly increased in absorbance to a high level (off scale) below 350 nm. Three films were formed from the solution and the absorbance measured. The absorbance for each film had two peaks, one at 280 nm and another at 200 nm. The results are summarized in Table 15.

Table 15

| Coating Thickness | Absorbance 280 nm | Absorbance 200 nm |
|---|---|---|
| 0.8 μ | 1.999 | over scale |
| 892 Å | 0.223 | 0.995 |
| 800 Å | 0.2 | 1.03 |

CLAIMS:

1. An aqueous developable negative resist composition, comprising a solution of a sensitizer and a polymer system, the polymer system comprising a phenolic resin having a weight average molecular weight of at least about 7,000 and a novolak-type resin compatible with the phenolic resin, the sensitizer comprising a compound selected from the group consisting of bisarylazides, monoarylazides and mixtures thereof, the solution having a total solids content of at least about 15%.

2. The composition of claim 1 wherein the phenolic resin is the represented by the following structural formula:

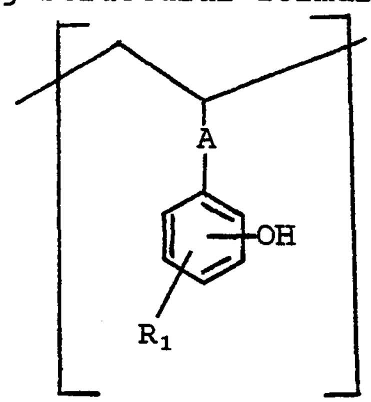

n,

wherein A is a covalent bond, -O-, $-CH_2-$, -OC(O)-, -C(O)O-, or $-C(O)OCH_2-$, and $R_1$ is -H, -F, -Cl, -Br or -I.

3. The composition of claim 1 wherein the phenolic resin is present in the composition in an amount of from about 10% to about 95% by weight of the polymer system in the composition.

4. The composition of claim 1 wherein the novolak-type resin is a cresol-formaldehyde novolak resin or a phenol-formaldehyde novolak resin.

5. The composition of claim 1 wherein the novolak-type resin is present in an amount of from about 5 to about 90% by weight of the polymer system in the composition.

6. The composition of claim 1 wherein the sensitizer is selected from the group consisting of

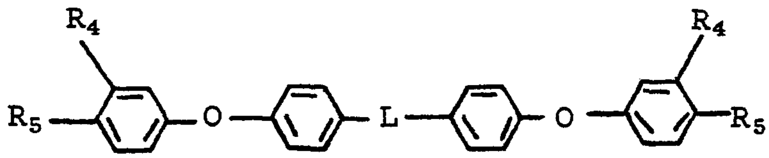 ,

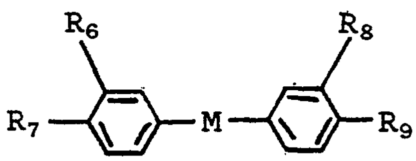 , 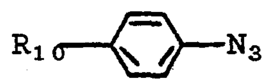

and mixtures thereof, wherein:

L is a covalent bond, $-CH_2-$, $-CH=CH-$, $-C(CH_3)_2-$, $-SO_2-$, $-CO-$, $-O-$, or $-S-$,

M is a covalent bond, $-O-$, $-S-$, $-SO_2-$, $-CH_2-$,

-CH 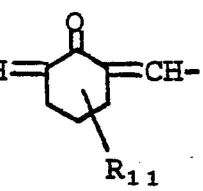 CH-, $-CH=CH-$, $-CH=CH-CO-$, $-CO-$, or $-C(CH_3)_2-$,

$R_4$, $R_5$, $R_6$, $R_7$, $R_8$, $R_9$ and $R_{10}$ are selected independently from -H and $-N_3$, provided that $R_4 \neq R_5$, and provided that $R_6$ and $R_7$ cannot be $-N_3$ at the same time, $R_8$ and $R_9$ cannot be $-N_3$ at the same time and at least one of $R_6$, $R_7$, $R_8$ and $R_9$ is $-N_3$, and

$R_{11}$ is -H or monovalent $C_1$ to $C_9$ alkyl.

7. The composition of claim 1 wherein the sensitizer is present in an amount of from about

 

4% by weight of the total solids in the composition up to the saturation point of the sensitizer.

8. The composition of claim 1 wherein the solvent is selected from the group consisting of aliphatic ketones, aliphatic esters, alkylene glycol monoalkyl ethers, dialkylene glycol monoalkyl ethers, alkylene glycol dialkyl ethers, and mixtures thereof.

9. The composition of claim 1 wherein the total solids content of the composition is within the range of from about 15% to about 40%.

10. A deep ultra violet sensitive, aqueous developable negative resist composition, comprising a solution of a deep ultra violet sensitizer and a polymer system, the polymer system comprising a phenolic resin having a weight average molecular weight of at least about 7,000, and a novolak-type resin compatible with the phenolic resin, the phenolic resin is represented by the following structural formula:

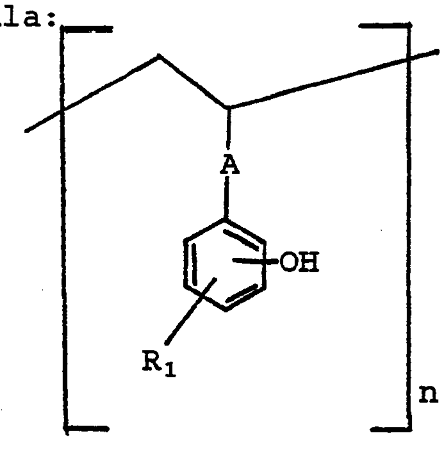

wherein:

A is a covalent bond, -O-, $-CH_2-$, -OC(O)-, -C(O)O-, or $-C(O)OCH_2-$, and $R_1$ is -H, -F, -Cl, -Br or -I,

the phenolic resin is present in an amount of from about 10% to about 95% by weight of the polymer system in the composition, the novolak-type resin is present in an amount of from about 15% to about 90% by weight of the polymer system in the composition, the deep ultra violet sensitizer is a compound selected from the group consisting of

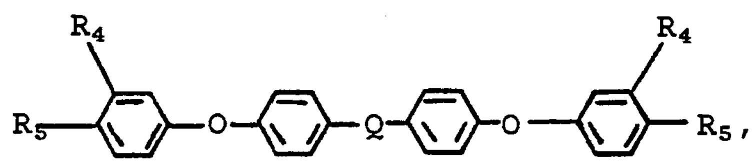

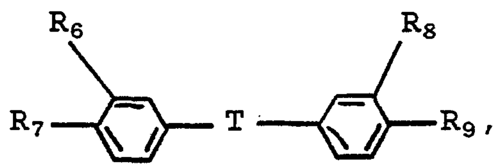

and mixtures thereof, wherein:

Q and T are selected independently from $-CH_2-$, $-C(CH_3)_2-$, $-SO_2-$, -CO-, -O-, and -S-, and

$R_4$, $R_5$, $R_6$, $R_7$, $R_8$, and $R_9$ are selected independently from -H and $-N_3$, provided that $R_4 \neq R_5$, and provided that $R_6$ and $R_7$ cannot be $-N_3$ at the same time, $R_8$ and $R_9$ cannot be $-N_3$ at the same time and at least one of $R_6$, $R_7$, $R_8$ and $R_9$ is $-N_3$,

the sensitizer is present in an amount of about 4% by weight of the total solids in the composition up to the saturation point of the sensitizer, the solvent is a mixture of ethylcellosolve acetate, butyl acetate, and xylene, and the composition has a total solids content of from about 15% to about 40%.